# EUROPEAN PATENT APPLICATION

(11) **EP 4 800 929 A1**
(43) Date of publication of application: **02.09.2026**
(21) Application number: 24881680.3
(22) Date of filing: 24.10.2024
(51) Int. Cl.: H04B 1/40

(54) **RADIO-FREQUENCY ARCHITECTURE, AND ELECTRONIC DEVICE**

(30) Priority: 27.10.2023 CN 202311412157
(71) Applicant: Vivo Mobile Communication Co., Ltd., Dongguan, Guangdong 523863 (CN)
(72) Inventor: LI, Mengmeng, Dongguan, Guangdong 523863 (CN); YUAN, Wenlong, Dongguan, Guangdong 523863 (CN); YIN, Fei, Dongguan, Guangdong 523863 (CN)
(74) Representative: Lavoix
(86) International application number: PCT/CN2024/126974
(87) International publication number: WO 2025/087316

(57) **Abstract**

This application discloses a radio-frequency architecture and an electronic device. The radio-frequency architecture includes a main module, a diversity module, a first power amplifier module, a second power amplifier module, and an antenna module; the diversity module is connected to the antenna module, to receive signals in a first communication standard and a second communication standard; the first power amplifier module is connected to the antenna module through the main module, to receive and send a signal in one of the first communication standard and the second communication standard; and the second power amplifier module is connected to the antenna module through a first path, to receive and send a signal in the other of the first communication standard and the second communication standard; or the second power amplifier module is separately connected to the antenna module through the first path and a second path, to receive and send signals in the first communication standard and the second communication standard, where the first path is a path that does not pass through the main module, and the second path is a path that passes through the main module.

## Description

### CROSS-REFERENCE TO RELATED APPLICATIONS

This application claims priority to Chinese Patent Application No. 202311412157.0, filed with the China National Intellectual Property Administration on October 27, 2023 and entitled "RADIO-FREQUENCY ARCHITECTURE AND ELECTRONIC DEVICE", which is incorporated herein by reference in its entirety.

### TECHNICAL FIELD

This application belongs to the field of communication technologies, and in particular, to a radio-frequency architecture and an electronic device.

### BACKGROUND

At present, the 5th generation mobile communication technology (5th Generation Mobile Communication Technology, 5G) connection in the world can be divided into two types: standalone (Standalone, SA) and non-standalone (Non-Standalone, NSA). SA operates in only a 5G frequency band (or referred to as a new radio (New Radio, NR) frequency band), while NSA operates both in a 4G frequency band (or referred to as a long term evolution (Long Term Evolution, LTE) frequency band) and the 5G frequency band (or referred to as an NR frequency band). The 4G frequency band is used for a control signal, and the 5G frequency band is used for a data signal. An NSA connection manner is generally required in most regions of the world. To satisfy that electronic devices used in most regions of the world support the NSA, it is required that transceiver (Transceiver, TRX) signals of both an LTE frequency band and an NR frequency band in a radio-frequency architecture can exist simultaneously. However, in a current radio-frequency architecture supporting the NSA, generally, a complex coexisting circuit and a plurality of independent antennas of LTE and NR are used to ensure that TRX signals in the LTE frequency band and the NR frequency band operate simultaneously, resulting in an increased quantity of antennas and high system complexity. In addition, the current radio-frequency architecture supporting the NSA cannot satisfy a requirement on general applicability in a plurality of regions of the world.

### SUMMARY

Embodiments of this application aim to provide a radio-frequency architecture and an electronic device, to resolve a problem that a current radio-frequency architecture supporting NSA has a large quantity of antennas and high system complexity, and cannot satisfy a requirement on general applicability in a plurality of regions of the world.

According to a first aspect, an embodiment of this application provides a radio-frequency architecture, including a main module, a diversity module, a first power amplifier module, a second power amplifier module, and an antenna module;
the diversity module is connected to the antenna module, to receive signals in a first communication standard and a second communication standard;
the first power amplifier module is connected to the antenna module through the main module, to receive and send a signal in one of the first communication standard and the second communication standard; and
the second power amplifier module is connected to the antenna module through a first path, to receive and send a signal in the other of the first communication standard and the second communication standard; or the second power amplifier module is separately connected to the antenna module through the first path and a second path, to receive and send signals in the first communication standard and the second communication standard, where
the first path is a path that does not pass through the main module, and the second path is a path that passes through the main module.

According to a second aspect, an embodiment of this application provides an electronic device, including the radio-frequency architecture described above.

In this embodiment of this application, the diversity module is connected to the antenna module, to receive signals in the first communication standard and the second communication standard; the first power amplifier module is connected to the antenna module through the main module, to receive and send a signal in one of the first communication standard and the second communication standard; and the second power amplifier module is connected to the antenna module through a first path that does not pass through the main module, to receive and send a signal in the other of the first communication standard and the second communication standard; or the second power amplifier module is separately connected to the antenna module through the first path and a second path that passes through the main module, to receive and send signals in the first communication standard and the second communication standard. In this way, the antenna module may be shared by designing signal receiving and sending in the first communication standard and the second communication standard, to ensure that when the radio-frequency architecture supports NSA, an increase in a quantity of antennas is avoided, and it is beneficial to reducing system complexity. In addition, the radio-frequency architecture in this embodiment may support signal receiving and sending in two signal standards: the first communication standard and the second communication standard, and therefore, may satisfy different frequency band requirements in different regions of the world, thereby resolving a problem that a current radio-frequency architecture cannot satisfy a requirement on general applicability in a plurality of regions of the world.

### BRIEF DESCRIPTION OF THE DRAWINGS

FIG. 1 is a first schematic diagram of a radio-frequency architecture according to an embodiment of this application; and
FIG. 2 is a second schematic diagram of a radio-frequency architecture according to an embodiment of this application.

### DETAILED DESCRIPTION

The following clearly describes the technical solutions in the embodiments of this application with reference to the accompanying drawings in the embodiments of this application. Apparently, the described embodiments are some of the embodiments of this application rather than all of the embodiments. All other embodiments obtained by a person of ordinary skill in the art based on the embodiments of this application shall fall within the protection scope of this application.

The terms "first", "second", and the like in this specification and claims of this application are used to distinguish between similar objects instead of describing a specific order or sequence. It should be understood that data used in this way are interchangeable in proper circumstances, so that the embodiments of this application can be implemented in another sequence other than those illustrated or described herein. In addition, the objects distinguished by "first" and "second" generally belong to the same category and a number of the objects is not limited. For example, there may be one or more first objects.

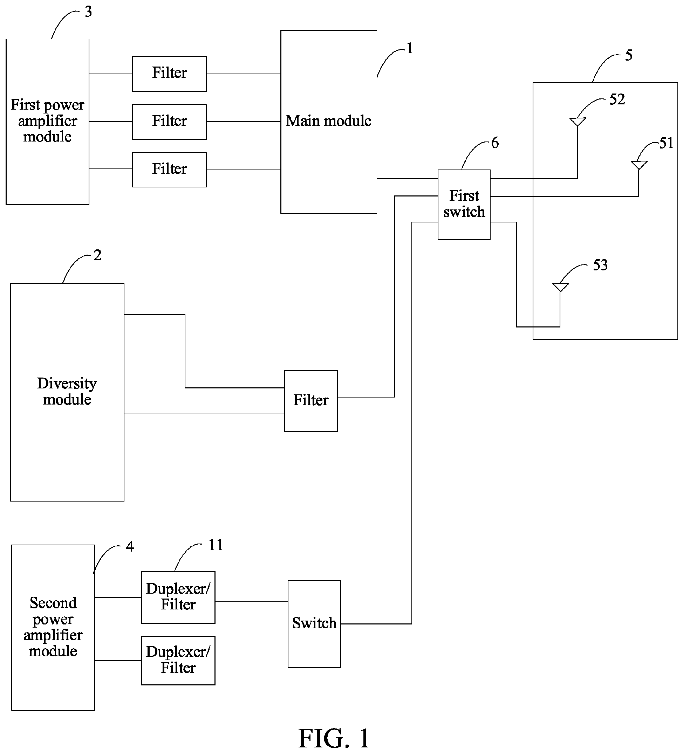

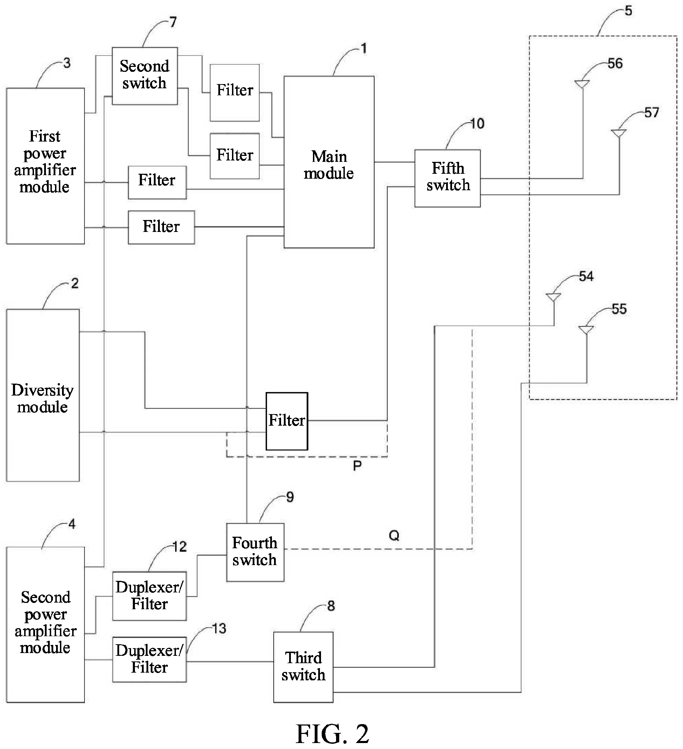

As shown in FIG. 1 and FIG. 2, an embodiment of this application provides a radio-frequency architecture, including a main module 1, a diversity module 2, a first power amplifier module 3, a second power amplifier module 4, and an antenna module 5.

The diversity module 2 is connected to the antenna module 5, to receive signals in a first communication standard and a second communication standard.

The first power amplifier module 3 is connected to the antenna module 5 through the main module 1, to receive and send a signal in one of the first communication standard and the second communication standard.

The second power amplifier module 4 is connected to the antenna module 5 through a first path, to receive and send a signal in the other of the first communication standard and the second communication standard; or the second power amplifier module 4 is separately connected to the antenna module 5 through the first path and a second path, to receive and send signals in the first communication standard and the second communication standard.

The first path is a path that does not pass through the main module 1, and the second path is a path that passes through the main module 1.

Optionally, the main module 1 refers to a signal channel that can support receiving and sending, and the diversity module 2 refers to a signal channel that can support only receiving.

Specifically, in an implementation, the diversity module 2 is connected to the antenna module 5, to receive signals in a first communication standard and a second communication standard; the first power amplifier module 3 is connected to the antenna module 5 through the main module 1, to receive and send a signal in one of the first communication standard and the second communication standard; and the second power amplifier module 4 is connected to the antenna module 5 through a first path, to receive and send a signal in the other of the first communication standard and the second communication standard (that is, the second power amplifier module 4 is connected to the antenna module 5 not through the main module 1).

In this embodiment, for example, a channel that is between the first power amplifier module 3 and the antenna module 5 and that is connected through the main module 1 is configured to receive and send a signal in the first communication standard, and a channel that is between the second power amplifier module 4 and the antenna module 5 and that is connected not through the main module 1 is configured to receive and send a signal in the second communication standard. Alternatively, for example, a channel that is between the first power amplifier module 3 and the antenna module 5 and that is connected through the main module 1 is configured to receive and send a signal in the second communication standard, and a channel that is between the second power amplifier module 4 and the antenna module 5 and that is connected not through the main module 1 is configured to receive and send a signal in the first communication standard.

Specifically, in another implementation, the diversity module 2 is connected to the antenna module 5, to receive signals in the first communication standard and the second communication standard; the first power amplifier module 3 is connected to the antenna module 5 through the main module 1, to receive and send a signal in the first communication standard; and the second power amplifier module 4 is separately connected to the antenna module 5 through a first path and a second path, to receive and send signals in the first communication standard and the second communication standard (that is, at least one port of the second power amplifier module 4 may be connected to the antenna module 5 not through the main module 1, and another at least one port of the second power amplifier module 4 may further be connected to the antenna module 5 through the main module 1).

In this embodiment, for example, both a channel that is between the first power amplifier module 3 and the antenna module 5 and that is connected through the main module 1 and a channel that is between the second power amplifier module 4 and the antenna module 5 and that is connected through the main module 1 may be configured to receive and send a signal in the first communication standard; and a channel that is between the second power amplifier module 4 and the antenna module 5 and that is connected not through the main module 1 is configured to receive and send a signal in the second communication standard. Optionally, when there are a plurality of channels that are between the second power amplifier module 4 and the antenna module 5 and that are connected through the main module 1, all the channels that are between the second power amplifier module 4 and the antenna module 5 and that are connected through the main module 1 may be configured to receive and send a signal in the first communication standard; or a part of the channels that are between the second power amplifier module 4 and the antenna module 5 and that are connected through the main module 1 are configured to receive and send a signal in the first communication standard, and the other part of the channels that are between the second power amplifier module 4 and the antenna module 5 and that are connected through the main module 1 are configured to receive and send a signal in the second communication standard; or the like. This is not limited in this embodiment of this application.

In the radio-frequency architecture in this embodiment of this application, the diversity module 2 is connected to the antenna module 5, to receive signals in the first communication standard and the second communication standard; the first power amplifier module 3 is connected to the antenna module 5 through the main module 1, to receive and send a signal in one of the first communication standard and the second communication standard; and the second power amplifier module 4 is connected to the antenna module 5 through a first path that does not pass through the main module 1, to receive and send a signal in the other of the first communication standard and the second communication standard; or the second power amplifier module 4 is separately connected to the antenna module 5 through the first path and a second path that passes through the main module 1, to receive and send signals in the first communication standard and the second communication standard. In this way, the antenna module 5 may be shared by designing signal receiving and sending in the first communication standard and the second communication standard, to ensure that when the radio-frequency architecture supports NSA, an increase in a quantity of antennas is avoided, and it is beneficial to reducing system complexity. In addition, the radio-frequency architecture in this embodiment may support signal receiving and sending in two signal standards: the first communication standard and the second communication standard, and therefore, may satisfy different frequency band requirements in different regions of the world, thereby resolving a problem that a current radio-frequency architecture cannot satisfy a requirement on general applicability in a plurality of regions of the world.

Optionally, continue to refer to FIG. 1, in a case that the second power amplifier module 4 is connected to the antenna module 5 through the first path, the radio-frequency architecture further includes a first switch 6.

The diversity module 2 is connected to the antenna module 5 through the first switch 6, and the first power amplifier module 3 is connected to the antenna module 5 through the main module 1 and the first switch 6;
in a case that the second power amplifier module 4 is connected to the antenna module 5 through the first path, the first path includes the first switch 6; and
the first switch 6 is configured to switch at least one of the diversity module 2, the first power amplifier module 3, and the second power amplifier module 4 to be connected to the antenna module 5.

For example, a plurality of antenna units may be disposed in the antenna module 5, and the first switch 6 may be used to switch the diversity module 2, the first power amplifier module 3, and the second power amplifier module 4 to be respectively connected to different antenna units, or the first switch 6 may be used to switch at least two of the diversity module 2, the first power amplifier module 3, and the second power amplifier module 4 to time-division multiplex an antenna unit in the antenna module 5.

Specifically, the antenna module 5 includes: a first antenna unit 51, a second antenna unit 52, and a third antenna unit 53; and the first switch 6 has a plurality of conduction states, where the plurality of conduction states include at least one of the following:
when the first switch 6 is in a first conduction state, the diversity module 2 is connected to the first antenna unit 51;
when the first switch 6 is in a second conduction state, the first power amplifier module 3 is connected to the second antenna unit 52 through the main module 1; and
when the first switch 6 is in a third conduction state, the second power amplifier module 4 is connected to the third antenna unit 53 through the first path.

Optionally, the first switch 6 may be switched among the plurality of conduction states (that is, switched among the first conduction state, the second conduction state, and the third conduction state). Alternatively, the first switch 6 may be switched among the plurality of conduction states, or may be simultaneously in at least two conduction states (for example, being simultaneously in the first conduction state and the second conduction state, or being simultaneously in the second conduction state and the third conduction state, or being simultaneously in the first conduction state and the third conduction state, or being simultaneously in the first conduction state, the second conduction state, and the third conduction state), or the like. This is not limited in this embodiment of this application. For example, the first switch 6 may be a triple-pole, triple-throw switch, or another switch combination (for example, two double-pole, double-throw switches are used), so that the radio-frequency architecture can support the NSA. This is not limited in the embodiment of this application.

Optionally, the first power amplifier module 3 may further be connected to the main module 1 through a filter. Alternatively, optionally, the first power amplifier module 3 may further be connected to the main module 1 through a plurality of filters, to implement coverage of a plurality of frequency bands in the first communication standard, and the like. Optionally, a single-port transfer switch or the like may be used for a signal channel in the main module 1. This is not limited in this embodiment of this application.

Optionally, the second power amplifier module 4 may further be connected to the antenna module 5 through a first signal processing unit 11 (for example, the first signal processing unit 11 may include a duplexer and/or a filter). Alternatively, optionally, the second power amplifier module 4 may further be connected to the antenna module 5 through a plurality of first signal processing units 11 (for example, the first signal processing unit 11 may include a duplexer and/or a filter), to implement coverage of a plurality of frequency bands in the second communication standard (for example, when the second power amplifier module 4 is connected to the antenna module 5 through a plurality of first signal processing units 11, a switch may further be disposed between the plurality of first signal processing units 11 and the antenna module 5, to switch channels of different frequency bands of the second power amplifier module 4 to be connected to the antenna module 5). This is not limited in this embodiment of this application.

It should be noted that, the filter and/or the duplexer in this embodiment of this application may be selected and designed based on a use region of an electronic device to which the radio-frequency architecture is applied. This is not specifically limited in this embodiment of this application.

For example, the first communication standard is an LTE communication standard, and the second communication standard is an NR communication standard. During actual application, if the radio-frequency architecture is applied to an electronic device in a first region for use, the first power amplifier module 3 uses an NR power amplifier module, and the second power amplifier module 4 uses an LTE power amplifier module, the first power amplifier module 3 is connected to the antenna module 5 through the main module 1, to receive and send a signal in an NR frequency band; and the second power amplifier module 4 is connected to the antenna module 5 not through the main module 1, to receive and send a signal in an LTE frequency band. If the radio-frequency architecture is applied to an electronic device in a second region for use, the first power amplifier module 3 uses an LTE power amplifier module, and the second power amplifier module 4 uses an NR power amplifier module, the first power amplifier module 3 is connected to the antenna module 5 through the main module 1, to receive and send a signal in an LTE frequency band; and the second power amplifier module 4 is connected to the antenna module 5 not through the main module 1, to receive and send a signal in an NR frequency band.

Optionally, for the diversity module 2, during actual application, if the radio-frequency architecture is applied to an electronic device in the first region for use, a double-port transfer switch may be used for a signal channel in the diversity module 2; or if the radio-frequency architecture is applied to an electronic device in the second region for use, a single-port transfer switch may be used for a signal channel in the diversity module 2; or the like. This is not limited in this embodiment of this application.

In this embodiment, a radio-frequency architecture is used, and adjustment devices are selected, to satisfy different frequency band requirements in different regions of the world and support NSA, thereby having general applicability.

Optionally, continue to refer to FIG. 2, in a case that the second power amplifier module 4 is separately connected to the antenna module 5 through the first path and the second path, the second path includes a first sub-path, and the radio-frequency architecture further includes: a second switch 7.

The first power amplifier module 3 is connected to the antenna module 5 through the second switch 7 and the main module 1, a first port of the second power amplifier module 4 is connected to the antenna module 5 through the first sub-path, and the first sub-path includes the second switch 7.

The second switch 7 is configured to switch at least one of the first power amplifier module 3 and the second power amplifier module 4 to be connected to the main module 1, where both a channel between the first power amplifier module 3 and the antenna module 5 and a channel between the first port of the second power amplifier module 4 and the antenna module are configured to receive and send a signal in the first communication standard.

For example, the second switch 7 has a plurality of conduction states. Specifically, the plurality of conduction states include at least one of the following:
when the second switch 7 is in a first conduction state, the first power amplifier module 3 is connected to the main module 1; and
when the second switch 7 is in a second conduction state, the second power amplifier module 4 is connected to the main module 1.

Optionally, the second switch 7 may be switched among the plurality of conduction states (that is, switched between the first conduction state and the second conduction state). Alternatively, the second switch 7 may be switched among the plurality of conduction states, or may be simultaneously in a plurality of conduction states (for example, being simultaneously in the first conduction state and the second conduction state), or the like. This is not limited in this embodiment of this application.

In this embodiment, the channel between the first power amplifier module 3 and the antenna module 5 and the channel between the first port of the second power amplifier module 4 and the antenna module are set to receive and send signals in the first communication standard, so that different frequency band requirements of supporting the NSA in different regions can be satisfied.

For example, the first communication standard is an LTE communication standard, the first power amplifier module 3 may be an LTE power amplifier module, and the second power amplifier module may be an NR power amplifier module. During actual application, if the radio-frequency architecture is applied to an electronic device in the second region for use, the first power amplifier module 3 may be used to implement, through the channel between the main module 1 and the antenna module 5, signal receiving and sending in the LTE communication standard. If the radio-frequency architecture is applied to an electronic device in the first region for use, the second power amplifier module 4 may be used to implement, through the channel between the main module 1 and the antenna module 5, signal receiving and sending in the LTE communication standard. In this way, the radio-frequency architecture may satisfy different frequency band requirements in different regions of the world and support the NSA, and may reduce selection of adjustment devices and have higher general applicability for different frequency band requirements of supporting the NSA in different regions.

Optionally, the second switch 7 may further be connected to the main module 1 through a filter or the like. Alternatively, optionally, the first power amplifier module 3 may further be connected to the main module 1 through one or a plurality of filters, to implement coverage of a plurality of frequency bands in the first communication standard, and the like. Optionally, a single-port transfer switch or the like may be used for a signal channel in the main module 1. This is not limited in this embodiment of this application.

Optionally, in a case that the second power amplifier module 4 is separately connected to the antenna module through the first path and the second path, the second path includes a second sub-path; and
a second port of the second power amplifier module 4 is connected to the antenna module 5 through the first path, and a third port of the second power amplifier module 4 is connected to the antenna module 5 through the second sub-path.

Both a channel between the second port of the second power amplifier module 4 and the antenna module 5 and a channel between the third port of the second power amplifier module 4 and the antenna module 5 are configured to receive and send a signal in the second communication standard.

For example, the second communication standard is an NR communication standard, and the second power amplifier module 4 may be an NR power amplifier module. During actual application, if the radio-frequency architecture is applied to an electronic device in the second region for use, a channel that is between the second power amplifier module 4 and the antenna module 5 and that is connected not through the main module 1 is used to implement signal receiving and sending in the NR communication standard. If the radio-frequency architecture is applied to an electronic device in the first region for use, a channel that is between the second power amplifier module 4 and the antenna module 5 and that is connected through the main module 1 may be used to implement signal receiving and sending in the NR communication standard. In this way, the radio-frequency architecture may satisfy different frequency band requirements in different regions of the world and support the NSA, and may reduce selection of adjustment devices and have higher general applicability for different frequency band requirements of supporting the NSA in different regions.

Optionally, the radio-frequency architecture further includes: a third switch 8; and the second port of the second power amplifier module 4 is connected to the antenna module 5 through the first path, and the first path includes the third switch 8. The third switch 8 is configured to switch the second port of the second power amplifier module 4 to be connected to different antenna units in the antenna module 5.

Specifically, the antenna module 5 includes: a fourth antenna unit 54 and a fifth antenna unit 55; and the second port of the second power amplifier module 4 is separately connected to the fourth antenna unit 54 and the fifth antenna unit 55 through the first path, and the first path includes the third switch 8. The third switch 8 is configured to switch the second port of the second power amplifier module 4 to be connected to one of the fourth antenna unit 54 and the fifth antenna unit 55.

For example, the third switch 8 has a plurality of conduction states. The plurality of conduction states include at least one of the following:
when the third switch 8 is in a first conduction state, the second port of the second power amplifier module 4 is connected to the fourth antenna unit 54; and
when the third switch 8 is in a second conduction state, the second port of the second power amplifier module 4 is connected to the fifth antenna unit 55.

Optionally, the third switch 8 may be switched among the plurality of conduction states (that is, switched between the first conduction state and the second conduction state). Alternatively, the third switch 8 may be switched among the plurality of conduction states, or may be simultaneously in a plurality of conduction states (for example, being simultaneously in the first conduction state and the second conduction state), or the like. This is not limited in this embodiment of this application.

In this embodiment, the third switch 8 is used to switch the second port of the second power amplifier module 4 to be connected to one of the fourth antenna unit 54 and the fifth antenna unit 55, to further implement functions such as coverage of a plurality of frequency bands in the NR communication standard or polling for receiving and sending. This is not limited in this embodiment of this application.

Optionally, the second port of the second power amplifier module 4 may further be connected to the third switch 8 through a second signal processing unit 12 (for example, the second signal processing unit 12 may include a filter and/or a duplexer), which may be specifically designed and selected based on a specific covered NR frequency band. This is not limited in this embodiment of this application.

Optionally, the radio-frequency architecture further includes: a fourth switch 9, and the second sub-path includes the fourth switch 9.

The third port of the second power amplifier module 4 is further connected to the antenna module 5 through a third path (that is, a jumper Q in FIG. 2), where the third path is a path that does not pass through the main module 1.

The fourth switch 9 is configured to switch the third port of the second power amplifier module 4 to be connected to the antenna module 5 with or without passing through the main module 1.

For example, the fourth switch 9 has a plurality of conduction states and may be switched among the plurality of conduction states. The plurality of conduction states include:
when the fourth switch 9 is in a first conduction state, the third port of the second power amplifier module 4 is connected to the antenna module 5 through the main module 1; and
when the fourth switch 9 is in a second conduction state, the third port of the second power amplifier module 4 is connected to the antenna module 5 not through the main module 1.

Specifically, the third port of the second power amplifier module 4 is connected to the fourth antenna unit 54 through the third path, and the fourth switch 9 is configured to switch the third port of the second power amplifier module 4 to be connected to one of the main module 1 and the fourth antenna unit 54.

In this embodiment, the fourth switch 9 is used to design the jumper Q, so that when the radio-frequency architecture is applied to an electronic device in the first region for use, there are a plurality of design options. In addition, the fourth switch 9 is used to switch the third port of the second power amplifier module 4 to be connected to one of the main module 1 and the fourth antenna unit 54, to further implement functions such as coverage of a plurality of frequency bands in the NR communication standard or polling for receiving and sending. This is not limited in this embodiment of this application.

Optionally, the third port of the second power amplifier module 4 may further be connected to the fourth switch 9 through a third signal processing unit 13 (for example, the third signal processing unit 13 includes a filter and/or a duplexer), which may be specifically designed and selected based on a specific covered NR frequency band. This is not limited in this embodiment of this application.

Optionally, in a case that the second power amplifier module 4 is separately connected to the antenna module through the first path and the second path, the radio-frequency architecture further includes a fifth switch 10; the diversity module 2 and the main module 1 are respectively connected to the antenna module 5 through the fifth switch 10; and the fifth switch 10 is configured to switch at least one of the diversity module 2 and the main module 1 to be connected to the antenna module 5.

For example, the fifth switch 10 has a plurality of conduction states. The plurality of conduction states include at least one of the following:
when the fifth switch 10 is in a first conduction state, the diversity module 2 is connected to the antenna module 5; and
when the fifth switch 10 is in a second conduction state, the main module 1 is connected to the antenna module 5.

For example, a plurality of antenna units may be disposed in the antenna module 5, and the fifth switch 10 may be used to switch the diversity module 2 and the main module 1 to be respectively connected to different antenna units.

Specifically, the antenna module 5 includes: a sixth antenna unit 56 and a seventh antenna unit 57; and the fifth switch 10 has a plurality of conduction states, where in a first conduction state, the diversity module 2 is connected to the sixth antenna unit 56; and in a second conduction state, the main module 1 is connected to the seventh antenna unit 57.

Optionally, the fifth switch 10 may be switched among the plurality of conduction states (that is, switched between the first conduction state and the second conduction state). Alternatively, the fifth switch 10 may be switched among the plurality of conduction states, or may be simultaneously in a plurality of conduction states (for example, being simultaneously in the first conduction state and the second conduction state), or the like. This is not limited in this embodiment of this application.

For example, the fifth switch 10 may be a double-pole, double-throw switch, or another switch combination, so that the radio-frequency architecture can support the NSA. This is not limited in the embodiment of this application.

Optionally, the diversity module 2 may be connected to the fifth switch 10 through a filter, a duplexer, or the like. For example, when the radio-frequency architecture is applied to an electronic device in the second region for use, no filter, duplexer, or the like (for example, a jumper P may be used in FIG. 2) may be disposed between the diversity module 2 and the fifth switch 10. This is not limited in this embodiment of this application.

Optionally, for the diversity module 2, during actual application, if the radio-frequency architecture is applied to an electronic device in the first region for use, a double-port transfer switch may be used for a signal channel in the diversity module 2; or if the radio-frequency architecture is applied to an electronic device in the second region for use, a single-port transfer switch may be used for a signal channel in the diversity module 2; or the like. This is not limited in this embodiment of this application.

In the foregoing embodiment, a circuit board related to one radio-frequency architecture may be used to satisfy a coverage requirement of a plurality of frequency bands of supporting the NSA in different regions, thereby reducing development costs, solving a problem that a current radio-frequency architecture supporting the NSA has a large quantity of antennas and high system complexity, and can satisfy a requirement of general applicability in a plurality of regions of the world.

An embodiment of this application further provides an electronic device, including the radio-frequency architecture in at least one of the foregoing embodiments, and being capable of achieving a same technical effect of the radio-frequency architecture in the foregoing embodiments. To avoid repetition, details are not described herein again.

The embodiments in this specification are all described in a progressive manner. Descriptions of each embodiment focus on differences from other embodiments, and same or similar parts among respective embodiments may be mutually referenced.

Although preferred embodiments of the embodiments of this application have been described, those skilled in the art can make other changes and modifications to these embodiments once they learn the basic inventive concept. Therefore, the following claims are intended to cover the preferred embodiments and all changes and modifications falling within the scope of the embodiments of this application.

Finally, it should be further noted that the term "include", "comprise", or any other variant is intended to cover a non-exclusive inclusion, so that a process, a method, an article, or a terminal device that includes a list of elements not only includes those elements but also includes other elements that are not explicitly listed, or further includes elements inherent to such a process, method, article, or terminal device. In absence of more constraints, an element preceded by "includes a..." does not preclude the existence of other identical elements in the process, method, article, or terminal device that includes the element.

The above embodiments are preferred embodiments of this application. It should be noted that, within the technical concept of this application, those ordinarily skilled in the art can make various improvements and modifications, which shall all fall within the protective scope of this application.

## Claims

1. A radio-frequency architecture, wherein the radio-frequency architecture comprises: a main module, a diversity module, a first power amplifier module, a second power amplifier module, and an antenna module;
the diversity module is connected to the antenna module, to receive signals in a first communication standard and a second communication standard;
the first power amplifier module is connected to the antenna module through the main module, to receive and send a signal in one of the first communication standard and the second communication standard; and
the second power amplifier module is connected to the antenna module through a first path, to receive and send a signal in the other of the first communication standard and the second communication standard; or the second power amplifier module is separately connected to the antenna module through the first path and a second path, to receive and send signals in the first communication standard and the second communication standard, wherein
the first path is a path that does not pass through the main module, and the second path is a path that passes through the main module.

2. The radio-frequency architecture according to claim 1, wherein the radio-frequency architecture further comprises: a first switch;
the diversity module is connected to the antenna module through the first switch, and the first power amplifier module is connected to the antenna module through the main module and the first switch;
in a case that the second power amplifier module is connected to the antenna module through the first path, the first path comprises the first switch; and
the first switch is configured to switch at least one of the diversity module, the first power amplifier module, and the second power amplifier module to be connected to the antenna module.

3. The radio-frequency architecture according to claim 2, wherein the antenna module comprises: a first antenna unit, a second antenna unit, and a third antenna unit; and
the first switch has a plurality of conduction states, wherein when the first switch is in a first conduction state, the diversity module is connected to the first antenna unit; when the first switch is in a second conduction state, the first power amplifier module is connected to the second antenna unit through the main module; and when the first switch is in a third conduction state, the second power amplifier module is connected to the third antenna unit through the first path.

4. The radio-frequency architecture according to claim 1, wherein in a case that the second power amplifier module is separately connected to the antenna module through the first path and the second path, the second path comprises a first sub-path, and the radio-frequency architecture further comprises: a second switch;
the first power amplifier module is connected to the antenna module through the second switch and the main module, a first port of the second power amplifier module is connected to the antenna module through the first sub-path, and the first sub-path comprises the second switch; and
the second switch is configured to switch at least one of the first power amplifier module and the second power amplifier module to be connected to the main module, wherein both a channel between the first power amplifier module and the antenna module and a channel between the first port of the second power amplifier module and the antenna module are configured to receive and send a signal in the first communication standard.

5. The radio-frequency architecture according to claim 1 or 4, wherein in a case that the second power amplifier module is separately connected to the antenna module through the first path and the second path, the second path comprises a second sub-path; and
a second port of the second power amplifier module is connected to the antenna module through the first path, and a third port of the second power amplifier module is connected to the antenna module through the second sub-path, wherein
both a channel between the second port of the second power amplifier module and the antenna module and a channel between the third port of the second power amplifier module and the antenna module are configured to receive and send a signal in the second communication standard.

6. The radio-frequency architecture according to claim 5, wherein the radio-frequency architecture further comprises: a third switch; and the antenna module comprises: a fourth antenna unit and a fifth antenna unit;
the second port of the second power amplifier module is separately connected to the fourth antenna unit and the fifth antenna unit through the first path, and the first path comprises the third switch; and
the third switch is configured to switch the second port of the second power amplifier module to be connected to one of the fourth antenna unit and the fifth antenna unit.

7. The radio-frequency architecture according to claim 5, wherein the radio-frequency architecture further comprises a fourth switch, and the second sub-path comprises the fourth switch;
the third port of the second power amplifier module is further connected to the antenna module through a third path, wherein the third path is a path that does not pass through the main module; and
the fourth switch is configured to switch the third port of the second power amplifier module to be connected to the antenna module with or without passing through the main module.

8. The radio-frequency architecture according to claim 1, wherein in a case that the second power amplifier module is separately connected to the antenna module through the first path and the second path, the radio-frequency architecture further comprises: a fifth switch;
the diversity module and the main module are respectively connected to the antenna module through the fifth switch; and
the fifth switch is configured to switch at least one of the diversity module and the main module to be connected to the antenna module.

9. The radio-frequency architecture according to claim 8, wherein the antenna module comprises: a sixth antenna unit and a seventh antenna unit; and
the fifth switch has a plurality of conduction states, wherein when the fifth switch is in a first conduction state, the diversity module is connected to the sixth antenna unit; and when the fifth switch is in a second conduction state, the main module is connected to the seventh antenna unit.

10. The radio-frequency architecture according to claim 1, wherein the first communication standard is a Long Term Evolution (LTE) communication standard, and the second communication standard is a New Radio (NR) communication standard.

11. The radio-frequency architecture according to claim 3, wherein the first switch is configured to switch the diversity module, the first power amplifier module, and the second power amplifier module to be respectively connected to different antenna units in the antenna module; or
the first switch is configured to switch at least two of the diversity module, the first power amplifier module, and the second power amplifier module, to time-division multiplex an antenna unit in the antenna module.

12. The radio-frequency architecture according to claim 7, wherein the antenna module comprises a fourth antenna unit, the third port of the second power amplifier module is connected to the fourth antenna unit through the third path, and the fourth switch is configured to switch the third port of the second power amplifier module to be conducted to one of the main module and the fourth antenna unit.

13. The radio-frequency architecture according to claim 1, wherein the first power amplifier module is connected to the main module through a filter.

14. The radio-frequency architecture according to claim 4, wherein the first power amplifier module is connected to the second switch, and the second switch is connected to the main module through a filter.

15. An electronic device, comprising the radio-frequency architecture according to any one of claims 1 to 14.
